# EUROPEAN PATENT APPLICATION

(11) **EP 2 728 387 A1**
(43) Date of publication of application: **07.05.2014**
(21) Application number: 12190846.1
(22) Date of filing: 31.10.2012
(51) Int. Cl.: G01V 8/10, G01J 5/00, G01S 17/02, G06F 3/041

(54) **Proximity sensor module**

(71) Applicant: ams AG, 8141 Unterpremstätten (AT)
(72) Inventor: Wang, Yu, Kemp, TX 75143 (US); Glover, Kerry, Rockwall, TX 75087 (US); Mehrl, David, Plano, TX 75025 (US); Dunn, Tom, Dallas, TX 75248 (US)
(74) Representative: Epping - Hermann - Fischer

(57) **Abstract**

A proposed proximity sensor module comprises a light emitting device (1) and a photo-detector (3) covered by a cover (2). The light emitting device is being designed for emitting light into the cover. Furthermore, the photo-detector is being designed for detecting light scattered and/or reflected by the cover. The cover comprises a dye-based ink layer (4) which, at least partly, covers a surface facing the light emitting device and the photo-detector. The ink layer is being translucent to the light emitted by the light emitting device.

## Description

This invention relates to a proximity sensor module.

Optical proximity sensors operate by flashing light towards a surface and measuring the amount of reflected light from that surface. These sensors often include a light emitting device like a LED or a laser emitting in the infrared. Detection of light indicates a proximity event and uses a photo-detector implemented with a photodiode. The sensor is often built into other devices like mobile phones or PDAs and comprises a transparent protection cover and an ink layer printed on the protection cover. Infrared (IR) transmissive inks are widely used with optical proximity sensors, e.g. to hide inside structures behind cover glass due to design reasons. Currently, such IR transmissive inks are pigment based and have particle sizes in the range of several microns, and transition wavelengths around 800 nm.

For optical proximity sensors, however, light needs to pass through the ink layer and cover glass to reach a target. Furthermore, the returned light is relatively weak and is prone to noise. Scattered light generated by the ink layer may add strong optical crosstalk, and often reduces the signal to noise ratio of the proximity sensor. In optical proximity sensor design, optical barriers made from opaque material are often used to shield the photo-detector from stray light and establish optical paths for improved crosstalk reduction.

There is a need, however, for simple and cost effective solutions to improve signal to noise ratio in optical proximity sensors.

The above objective is solved by the subject matter of the independent claim. Further developments and embodiments are subject to dependent claims.

According to one aspect of the invention, a proximity sensor module comprises a light emitting device and a photo-detector covered by a cover. The cover comprises a dye-based ink layer which at least covers part of a surface facing the light emitting device and the photo-detector. Preferably, the light emitting device and the photo-detector are placed side by side such that the light emitting device emits light into the cover. This light is scattered and/or reflected by the cover and is detected by the photo-detector. In particular, the ink layer is being translucent to the light emitted by the light emitting device.

Light scattering in the dye-based ink layer can be kept rather small. When compared to a scattering caused by pigment-based ink layers, scattering is reduced by several orders of magnitude because of comparably smaller particle sizes. Light scattering, in general, depends on sizes of the ink particles. The larger the particle sizes, the stronger will be the scattering. Pigment-based inks have particle sizes in the range of several microns, while dye molecules are in the size of few nanometers. Therefore the dye-based ink layer has less scattering than the pigment-based inks. As a consequence, the overall crosstalk of the proximity sensor module caused by scattering can be significantly reduced. Dye-based ink layers can also be produced in a cost-effective way as a huge variety of dyes are available on the market. Spectral characteristics like colour and transmission wavelength can be largely tuned to the liking and many dyes feature improved durability such as few bleaching.

Hereinafter, the term transparent relates to the physical property of allowing light to pass through a material without being significantly scattered. Furthermore, the term translucent relates to the physical property of allowing light to pass through a material; but, light passing through a translucent material does not necessarily follow Snell's law, i.e. a translucent medium allows the transport of light while a transparent medium not only allows the transport of light but allows for the image formation. Moreover, if not mentioned otherwise in this document, the term light denotes electromagnetic radiation comprising the infrared (in particular near infrared), visible and UV spectrum.

According to another aspect of the invention, the ink layer comprises dye molecules having particle sizes of less than a micron. Furthermore, it is preferred to use a light emitting device emitting light having an emission wavelength smaller than the particle size used for the ink layer.

According to another aspect of the invention, the particle sizes lie in the nanometer region, in particular between 1.5 and 4 nm. In this range of particle sizes, scattering in the ink layer of the light emitted by the light emitting device is dominated by Rayleigh scattering. In fact, particle sizes are comparably smaller than the emission wavelength of the light emitting device. To a good degree of approximation scattering is elastic scattering. In contrast, for higher particle sizes, e.g. particle sizes of more than one micron, light scattering is dominated by Mie scattering.

According to another aspect of the invention, the light emitted by the light emitting device comprises infrared radiation. Furthermore, the ink layer is transmissive to said infrared radiation; in particular the ink layer is transparent to infrared radiation.

Choosing infrared radiation further assures that sizes of the dye molecules are small enough to show Rayleigh scattering characteristics.

According to another aspect of the invention, the ink layer has low transmittance of visual light. In particular, transmittance lies in the range of less than 20%.

Mainly due to design reasons the ink layer is chosen to have low transmittance of visual light. This way the proximity sensor and its circuitry can be hidden away from sight and an optically appealing look can be achieved. Furthermore, crosstalk originating from ambient light outside the sensor can successfully be suppressed.

According to another aspect of the invention, the dye molecules in the ink layer have transition wavelengths different from the wavelength of the light emitted by the light emitting device.

When choosing a dye for a given application and in particular a given light emitting device, it may be advantageous to choose an appropriate transition wavelength of the dye. Direct excitation of the dye should be avoided. Furthermore, scattering in the Rayleigh approximation is wavelength dependent. In fact, scattering is highest near the transition wavelength. Thus, choosing a dye to account for both effects can result in further reduction of optical crosstalk.

According to another aspect of the invention, the ink layer comprises a dye mixture of different dye molecules. The individual dyes making up the dye mixture can be chosen to result in a desired final colour. For example, the dye mixture could have a black colour such that nearly no visible light is able to penetrate the ink layer. At the same time each of the individual dyes making up the dye mixture remains translucent to infrared radiation. This way the dye mixture still reduces crosstalk in the optical proximity sensor.

According to another aspect of the invention, the dye mixture has a black colour and is transparent to the light emitted by the light emitting device.

According to another aspect of the invention, the dye mixture comprises food dyes and/or ballpoint inks.

According to another aspect of the invention, the light emitting device comprises a light emitting diode or a laser.

According to another aspect of the invention, the photodetecting device comprises a photo-detector, a charge coupled device, a complementary metal oxide semiconductor or an avalanche photodiode.

According to another aspect of the invention, the cover comprises a glass plate or a plastic plate. In particular, the cover comprises a transparent glass plate or a transparent plastic plate.

According to another aspect of the invention, the light emitting device and the photo-detector are mounted on a common carrier. In particular, the common carrier comprises a printed circuit board and preferably comprises all necessary electrical connections to drive the individual components of the proximity sensor. Furthermore, both photo-detector and light emitting device are separated by an optical barrier.

According to another aspect of the invention, the optical barrier comprises an optically opaque material and is mounted on a common carrier positioned at least between the photo-detector and the light emitting device. Alternatively, or in addition, an optically opaque aperture is attached to a surface of the cover.

According to another aspect of the invention, the cover comprises a polarization selection device.

Besides scattering in the ink layer and inside the cover light emitted by the light emitting device is also reflected at the cover/air and ink layer/air interfaces. In order to reduce such reflection the polarization selection device can be used. Furthermore, if the polarization selection device is used to polarize the light emitted by the light emitting device, reflection can be reduced to a minimum if the light emitting device is positioned at the Brewster angle with respect to the cover.

In the following, the principle presented above will be described in more detail with respect to drawings in which exemplary embodiments are presented.
Figure 1 shows an exemplary embodiment of a proximity sensor module according to the principle presented;
Figure 2 shows an exemplary modelling of the result of light scattering versus particle size using Mie theory;
Figures 3A to 3C show an exemplary transmission spectra of dyes and dye-mixture according to the principle presented; and
Figure 4 shows an exemplary comparison of scattering in inks due to dye molecules and pigment particles according to the principle presented.

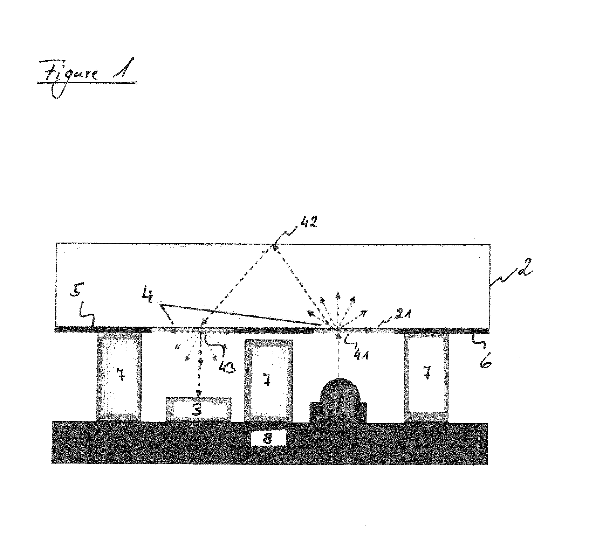

Figure 1 shows an exemplary embodiment of a proximity sensor module according to the principle presented. The (optical) proximity sensor module comprises a light emitting device 1, for example a LED or a laser, a transparent protection cover 2 such as a glass plate or a plastic plate, a photo-detector 3 like a photodiode, and an ink layer 4. The surface 5 of cover 2 faces both the light emitting device 1 and photo-detector 3. The ink layer 4 is printed on the surface 5 of the protection cover 2 and covers at least part of that surface. Other parts of surface 5 are covered with one or more non-reflective ink layers 6.

The cover 2 together with ink layer 4 and non-reflective ink layer 6 printed on surface 5 is mounted or attached to several optical barriers 7. These optical barriers 7 separate the light emitting device 1 and photo-detector 3 from each other. In this exemplary embodiment the optical barriers 7 are attached to or placed below the non-reflective ink layers 6. The optical barriers 7 are made from an opaque material and do not pass light. They constitute an optical barrier to block certain optical paths which otherwise would cause crosstalk. The light emitting device 1 and the photo-detector 3 as well as the optical barriers 7 are mounted and electrically connected with a printed circuit board 8.

In order to reduce reflection into the cover 2, e.g. by total internal reflection, and reflection back towards the light emitting device 1 preferably the cover 2 comprises a polarization selection device like a polarizing foil or coating. Furthermore, the light emitting device 1 is mounted beneath the ink layers 4 such that the emitted light hits the interface 41 perpendicularly.

An optical proximity sensor module is usually integrated in mobile devices like cell phones, PDAs, smart phones and the like. In many applications, the sensor and IR LED need to be hidden behind dark ink to make the appearance more attractive to the user. Sitting behind the cover the components of the sensor and its electronics are hidden away from sight by ink layer 4 and non-reflective ink layer 6. The material used with these layers, e.g. dyes in ink layer 4, can be chosen to give an optically pleasing or desired appearance.

In operation of the proximity sensor module light is emitted or flashed by light emitting device 1 into the cover. In this embodiment the light emitting device 1 is an infrared light emitting diode. The diode can be equipped with a lens on top of it in order to facilitate directed emission of infrared light towards cover 2. The emitted light gets reflected by air/glass (or air/plastic) interface 41, and additionally gets scattered by the ink layer 4. Furthermore, the emitted light after passing interface 41 gets reflected at another interface 42 at the top of the cover 2. It then moves to the bottom of the cover 2 and hits ink layer 4 again. Similarly, the light gets partly reflected and scattered at interface 43. Finally, a certain amount of light reaches photo-detector 3 to yield the detection signal which eventually indicates a proximity event. In particular, reflection at interface 42 gets altered if a target like a head or hand of a person is in close proximity.

Optical scattering leads to crosstalk which affects the signal to noise ratio of the proximity sensor module. As explained above the proximity sensor module in one mode of operation operates by flashing an (IR) light towards surface 5. The amount of reflected energy from that surface is then measured by the photo-detector 3. Thus, material properties of the ink layer 4 have a major impact on the performance of the proximity sensor and will be discussed with reference to the following Figures.

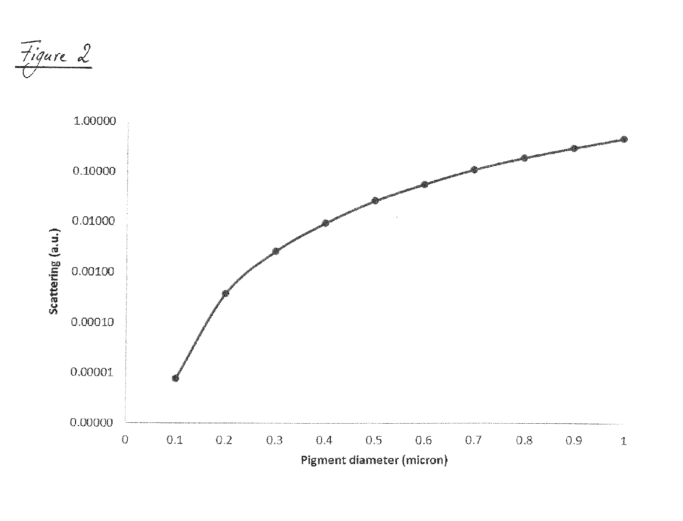

Figure 2 shows an exemplary modelling of the result of light scattering versus particle size using Mie theory. Pigment based inks have particles size in the range of several microns and generate strong light scattering. Light scattering is a form of scattering and can be considered as a deflection of a light ray from a straight path, for example, by non-uniformities in the propagation medium, particles, or in interfaces. Light scattering depends on particle size and wavelength of the light being scattered.

For small particles, light scattering can be approximated by Rayleigh scattering, which is based on elastic scattering of light by molecules or particles being much smaller than the wavelength of the incoming light. Rayleigh scattering is strongly dependent on the size of the particles and is proportional the sixth power of the particle diameter. For larger particles, light scattering the Rayleigh approximation is not valid any more and scattering rather follows the Mie model. The intensity of Mie scattering is generally not strongly dependent on the wavelength, but dependent on the particle size.

Figure 2 shows a modelling result of light scattering intensity (in arbitrary units a.u.) versus particle size (in microns) using the Mie scattering model as approximation. Within this model optical scattering increases by over four orders of magnitude when the particle size increases from 0.1 µm to 1 µm. Dye-based inks, however, do not contain large particles and their molecules are in the dimension of only a few nanometers.

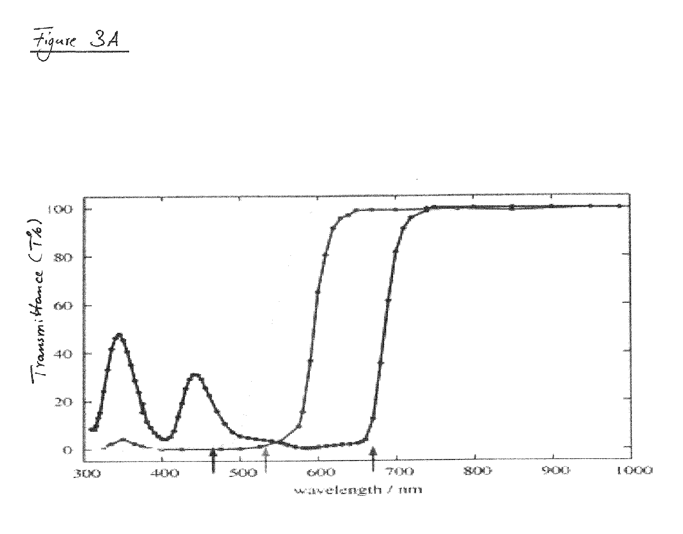

Figures 3A to 3C show exemplary transmission spectra of dyes and a dye-mixture according to the principle presented. Many dyes are transparent in the IR region and eventually have very high transmission in the IR. Figure 3A shows transmission spectra for some commercially available food colouring dyes by McCormick (Schilling). The curve in the middle is for their red dye, the curve on the left is for a yellow dye, and the curve on the right is for a blue dye (see http://www.av8n.com/imaging/dye-spectra.htm). All of the food dyes in Figure 3A are transparent in IR light as can be seen on the far right side.

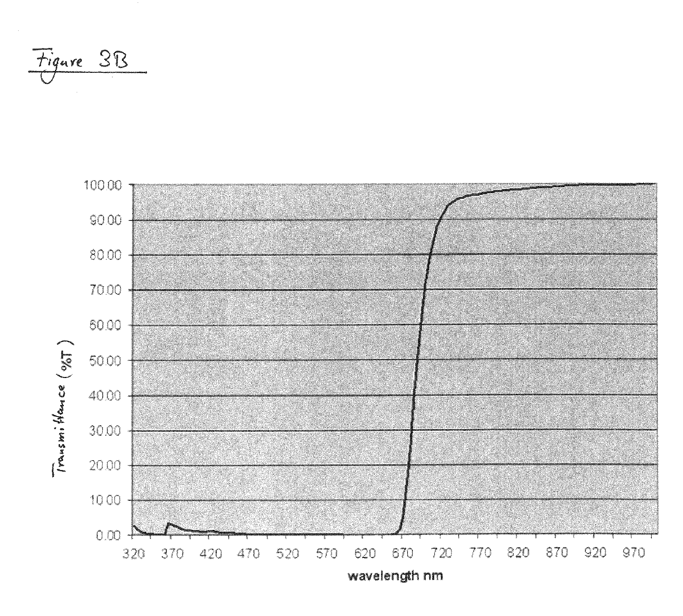

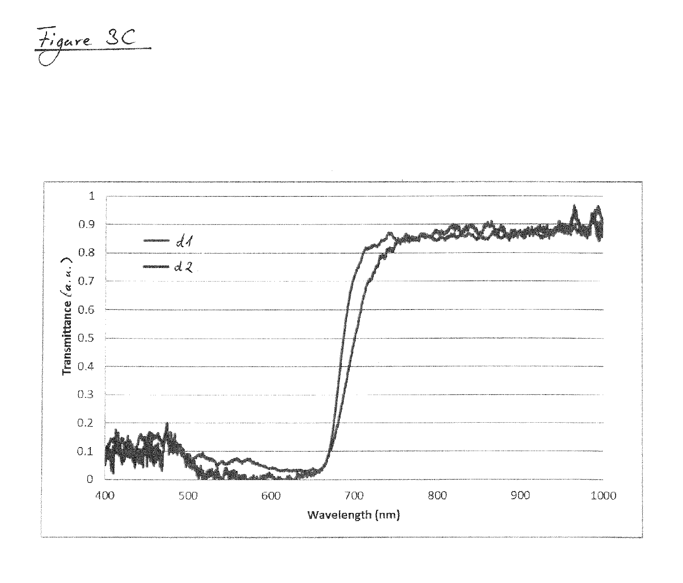

Figure 3B shows a transmission spectrum of the crystal violet dye, which is a major dye component of many ballpoint pen inks. It is transparent in the IR region, but opaque in the visible except in the deep blue wavelength. Figure 3C shows a comparison of some food dyes d1 and ballpoint pen inks d2. Essentially the spectral properties can be chosen to a large extent. As depicted, given spectral ranges can be realised with different dyes, allowing fine-tuning of apparent colour of the ink layer based on design considerations. For example, dyes of different types can be mixed to result in a black ink which on the other side remains transparent in IR, as shown in Figure 3C.

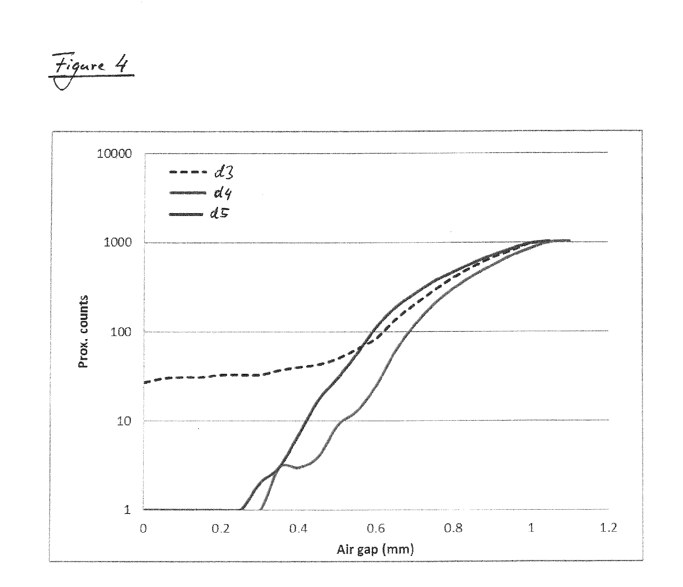

Figure 4 shows an exemplary comparison of scattering in inks due to dye molecules and pigment particles according to the principle presented. As the inks used with the ink layer 4 are dye-based, they do not have the large size of pigment particles. Based on scattering theory scattering should be considerably smaller leading to much less optical crosstalk than the pigment based inks. Figure 4 shows actual test results of optical crosstalk from a food dye d4 and a pen ink d5 in comparison with a pigment based IR ink d3 (Teikoku). Here the inks were tested with a proximity sensor module as disclosed in Figure 1 using a light emitting diode set at 100 mA and emitting eight pulses per second. The thickness of the cover was 1 mm made of glass. The food dye sample was a dye mixture of FD&C Blue #1, FC&C Green #3, FD&C Yellow #5 and FD&C Red #40. The pen ink was a mixture of Ball pen blue ink and red ink from Paper Mate ball pens.

Apparently both the food dye and the pen ink show much less crosstalk which is orders of magnitude less than the Teikoku inks.

### Reference numerals

- 1: light emitting device
- 2: cover
- 3: photo-detector
- 4: ink layer
- 41: scattering
- 42: reflection
- 43: scattering
- 5: surface of cover
- 6: opaque aperture
- 7: optical barrier
- 8: printed circuit boards
- d1: dye
- d2: dye
- d3: dye
- d4: dye
- d5: dye

## Claims

1. Proximity sensor module, comprising a light emitting device and a photo-detector covered by a cover, wherein
- the light emitting device is designed for emitting light into the cover,
- the photo-detector is designed for detecting light scattered and/or reflected by the cover; and
- the cover comprises a dye-based ink layer at least partly covering a surface facing the light emitting device and the photo-detector, the ink layer being translucent to the light emitted by the light emitting device.

2. Proximity sensor module according to claim 1, wherein the ink layer comprises dye molecules having particle sizes of less than a micron.

3. Proximity sensor module according to claim 2, wherein the particle sizes lie in the nanometer region, in particular between 1.5 and 4 nm, such that scattering in the ink layer of the light emitted by the light emitting device is dominated by Rayleigh scattering.

4. Proximity sensor module according to one of claims 1 to 3, wherein the light emitted by the light emitting device comprises infrared radiation and the ink layer is transmissive to said infrared radiation, in particular the ink layer is transparent to infrared radiation.

5. Proximity sensor module according to one of claims 1 to 4, wherein the ink layer has low transmittance of visual light, in particular transmittance of less than 20%.

6. Proximity sensor module according to one of claims 2 to 5, wherein the dye molecules in the ink layer have transition wavelengths different from the wavelength of the light emitted by the light emitting device.

7. Proximity sensor module according to one of claims 2 to 5, wherein the ink layer comprises a dye mixture of different dye molecules.

8. Proximity sensor module according to claim 7, wherein the dye mixture has a black colour and is transparent to the light emitted by the light emitting device.

9. Proximity sensor module according to claim 7 or 8, wherein the dye mixture comprises food dyes and/or ballpoint inks.

10. Proximity sensor module according to one of claims 1 to 9, wherein the light emitting device comprises a light emitting diode (LED) or a laser.

11. Proximity sensor module according to one of claims 1 to 10, wherein the photo detecting device comprises a photodiode, a charge coupled device (CCD), a complementary metal-oxide-semiconductor (CMOS), or an avalance photodiode (APD).

12. Proximity sensor module according to one of claims 1 to 11, wherein the cover comprises a glass plate or a plastic plate, in particular a transparent glass plate or a transparent plastic plate.

13. Proximity sensor module according to one of claims 1 to 12, wherein the light emitting device and the photo-detector are mounted on a common carrier, in particular a printed circuit board, and being separated by an optical barrier.

14. Proximity sensor module according to claims 13, wherein the optical barrier comprises
- an opaque material and is mounted on the common carrier at least between the photo-detector and the light emitting device and/or
- an aperture being attached to a surface of the cover.

15. Proximity sensor module, wherein the cover comprises a polarization selection device.
